# EUROPEAN PATENT SPECIFICATION

(11) **EP 0 712 269 B1**
(45) Date of publication and mention of the grant of the patent: **09.06.1999**
(21) Application number: 95117870.6
(22) Date of filing: 13.11.1995
(51) Int. Cl.: H05K 13/08

(54) **Method and apparatus for mounting a part at a specfific position**
Verfahren und Vorrichtung zur Montage eines Teils auf einer spezifische Position
Procédé et dispositif pour le montage d'un composant sur une position spécifique

(30) Priority: 11.11.1994 JP 27813794
(43) Date of publication of application: 15.05.1996
(73) Proprietor: YAMAHA HATSUDOKI KABUSHIKI KAISHA, Iwata-shi Shizuoka-ken, 438 (JP)
(72) Inventor: Hashimoto, Kazuhisa c/o Yamaha Hatsudoki K.K., Shizuoka-ken (JP)
(74) Representative: Grünecker, Kinkeldey, Stockmair & Schwanhäusser Anwaltssozietät

(56) References cited:
- EP-A- 0 582 086
- EP-A- 0 597 447

## Description

The present invention relates to a method of mounting a part at a specific position, in particular mounting an electronic part or an auxiliary part as for supporting the electronic part onto a substrate such as a printed circuit board, comprising the steps of picking up the part by an attracting nozzle, transferring the part and placing same within a detection area of an optical detection means, said optical detection means emits parallel light beams for detecting projected width data of the part, subjecting the part to a recognition process, wherein said projected width data are obtained under rotation of the part, and mounting the part at the desired position.

Furthermore, the present invention relates to an apparatus for mounting a part at a specific position, particularly mounting an electronic part or an auxiliary part as for supporting the electronic part onto a substrate such as a printed circuit board, comprising a movable mounting head unit having at least one attracting nozzle for picking up at least one part from a part supply unit, an optical detecting means emitting parallel light beams in a detection area for detecting a projected width data of the part, a control unit for controlling the movement of the nozzle in response to said projected width data, in particular for performing the above-mentioned method.

As to this invention, a method of recognizing a part is provided which is suited for a cylindrical part, in which deviation in the part pickup position is checked and a mounting position is corrected accordingly using optical detection means comprising a parallel light beam emitting section and a light receiving section of a surface mounter for picking up the small part by a pickup nozzle and mounting it on a board.

A type of surface mounter has been generally known in which small parts such as ICs, resistors, and capacitors are picked up by a parts pickup head unit having a pickup nozzle from a parts supply section, transferred over a positioned printed circuit board, and mounted to a specified position on the printed circuit board. In order to mount the part correctly in specified position on the printed circuit board, this type of mounter is required, if there is deviation in the part pickup position, to correct the deviation accordingly. Therefore, a method has been known as disclosed in the Japanese Unexamined Patent Application Hei 6-21697 in which the head unit is provided with a parallel light beam emitting section and a light receiving section, projected width of the part is detected by emitting the parallel light beam to the part while rotating the pickup nozzle with the picked up part located between the light emitting and receiving sections of the optical detection means, and a mounting position correction amount is obtained (see also EP-A-0 582 086).

Specifically, this method is used for chip parts of square shapes in which the projected width of the part is detected by the optical means while the pickup nozzle which has picked up the part is being rotated; the rotation angle, minimum projected width, projection center position of the part when the projected width of the part becomes the minimum are obtained from the detection data, and mounting position correction amounts in X, Y and rotary directions are calculated from those data.

The shape of the parts mounted by the mounter is varied. A special part is of a low height cylindrical shape, or a part of a cylindrical cross section (hereinafter called a cylindrical part). Also when the cylindrical part is mounted, if the nozzle center is displaced from the part center, correction of the mounting position is required accordingly. However, conventional method of recognition is not suited for the cylindrical parts.

In other words, with the conventional method described above, a rotary position is sought where the projected width of the part detected by the optical detection means becomes the minimum while the pickup nozzle which has picked up the part is being rotated. The mounting position correction amount is determined from the nozzle rotation angle and minimum projected width at that rotary position. If the part picked up by the pickup nozzle is cylindrical, the projected width corresponds to the diameter, and remains unchanged even if the pickup nozzle is rotated. Therefore, the method of seeking the rotary position where the projected width becomes the minimum cannot be used.

It is therefore an objective of the present invention to provide an improved method and an improved apparatus for mounting a cylindrical part, wherein the detection of the part is improved so that the mounting position is correctly determined and the picked up state of the part is more accurately recognized, although the part's shape deviates from a square or rectangular shape, and wherein particularly a cylindrical part is correctly recognized.

According to the present invention, the above-mentioned objective concerning the method is performed by the method according to claim 1. The method includes the steps of determining a first projected position of said cylindrical part attracted by said nozzle within said detection area, rotating said part by a predetermined rotary angle from said first position to a second position within said detection area and determining said second projected position.

Thus, by detecting projected positions of said part at different rotary states, it is determined the position of the part relative to the detection area so that said cylindrical part is recognized accurately.

According the invention, said first and second projected positions of said part are determined by detecting central projected positions of the part. Thus, it is possible to calculate displacement amount of the parts and relative to the nozzle center via the distance between the projected nozzle center and the projected central position of the part, at least at both of the rotary angles.

According to the invention, said part is formed as a cylindrical part having its central axis parallel or identical to an axis of said nozzle and perpendicular to a plane which is defined by the detection area. Said part being formed by cylindrical means so that the part has a cylindrical cross-section viewed in the direction of the light beam, preferably said cylindrical part is of a low height. The cylindrical part is not limited to an electronic part constituting an electronic element but may also be an auxiliary part which is mounted on printed circuit boards for supporting the electronic parts.

According to yet another aspect of the invention, said predetermined rotary angle is preferably set to 90° instead of setting to an arbitrary angle. As a result, the deviations of the center of the cylindrical part from the nozzle center are checked in two directions which are normal (i.e. perpendicular) to each other, so that the mounting position correction amounts for both X and Y directions are easily and immediately obtained.

According to yet another aspect of the invention, said part being subject to the light beams rotated via said nozzle around an axis substantially perpendicular to the light beams, and during rotation said projected position, said projection width and said rotary angle are repeatedly detected at least until a maximum or minimum displacement distance is determined between said projected position of said part and a known projected position corresponding to the nozzle center, and wherein said displacement distance reaches said maximum or said minimum when a line connected from a part center to the nozzle center extends substantially perpendicular to the parallel light beams and is within said detection area. This allows also easy and accurate determination of the pickup state of the cylindrical part.

According to the present invention, the above-mentioned objective concerning the apparatus is performed by an apparatus according to claim 15. A calculating section is provided for determining a first projected position of said part attracted by said nozzle within said detection area, said control unit rotating said part by a predetermined rotary angle from said first position to a second position within said detection area and in that said calculating section determines said second projected position.

According to a further aspect of the invention, said apparatus has at least a surface of the nozzle matt and/or dark coloured painted and/or has said nozzle formed with black resin. Such anti-reflected surface properties of the nozzle improves the accuracy of the detection of the part, as normally, light reflected at the nozzle would cause adverse effect on the part detection.

According to yet another aspect of the invention, an apparatus of the nozzle is provided with a connecting means which allow the nozzle to be detachably inserted into a receiving means of a nozzle holder, so that said nozzle is attached into said receiving means substantially without play. Therefore, pickup, recognition and mounting of the part are performed without play of the central axis of the pickup nozzle, so that stability and accuracy during those actions are assured.

According to a further aspect of the invention, said receiving means comprises two plates which are disposed relatively to each other bi-directional, and which allow to bring the upper part of the nozzle into abutting contact with the plates, and wherein spring means are provided for pressing the upper part of the nozzle against the bi-directional plates. Preferably, both of said spring means and said upper part of said nozzle are provided with a similarly formed section, which is to be brought into fittingly engagement. Accordingly, there is no play between the receiving means and the upper edge of the nozzle in all three dimensional directions.

Preferred embodiments of the invention are laid down in further dependent claims.

Hereinafter, the present invention is illustrated and explained in greater detail by means of preferred embodiments in conjunction with accompanying drawings, wherein:
Figure 1 is a schematic plan view of a mounting apparatus including a mounting head unit and a component supply unit according to the invention,
Figure 2 is a schematic front elevational view showing the mounting apparatus according to figure 1,
Figure 3 shows an enlarged view of the mounting head unit according to figure 1,
Figure 4 is a block diagram showing the control system of the apparatus according to figure 1,
Figure 5 is a schematic perspective view of a cylindrical part picked up by the pickup nozzle according to figure 1,
Figure 6 is a flow chart showing first and second embodiments of a recognition method of the apparatus according to figure 1,
Figure 7 is a schematic plan view of the detection area and a part in different positions which illustrates the first embodiment of a method according to figure 6,
Figure 8 is a schematic plan view of the detection area and the part in different rotated positions illustrating the second embodiment of the method according to figure 6,
Figure 9 is a flow chart showing a third embodiment of a recognition method according to figure 1,
Figure 10 is a schematic plan view of the detection area including a part at a maximum position and including a schematic side view of a light receiving section and a graph illustrating the positional displacement of the part according to figure 9,
Figure 11 shows a schematic side view of a nozzle and a part within the detection area according to figure 1,
Figure 12a shows a schematic perspective view of a nozzle holder of a nozzle head unit according to figure 1,
Figure 12b shows a schematic perspective view of a detachable nozzle to be received in the nozzle holder of figure 12a, and
Figure 13 shows a schematic front elevational view of a pickup nozzle inserted into the nozzle holder of figure 12a.

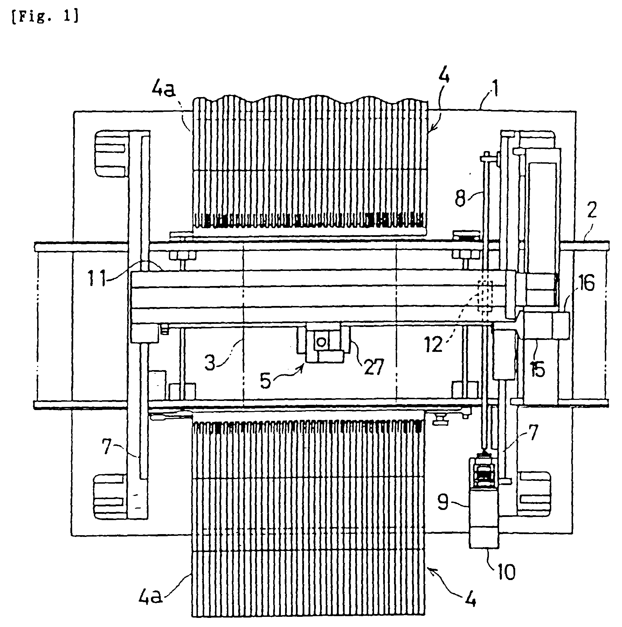

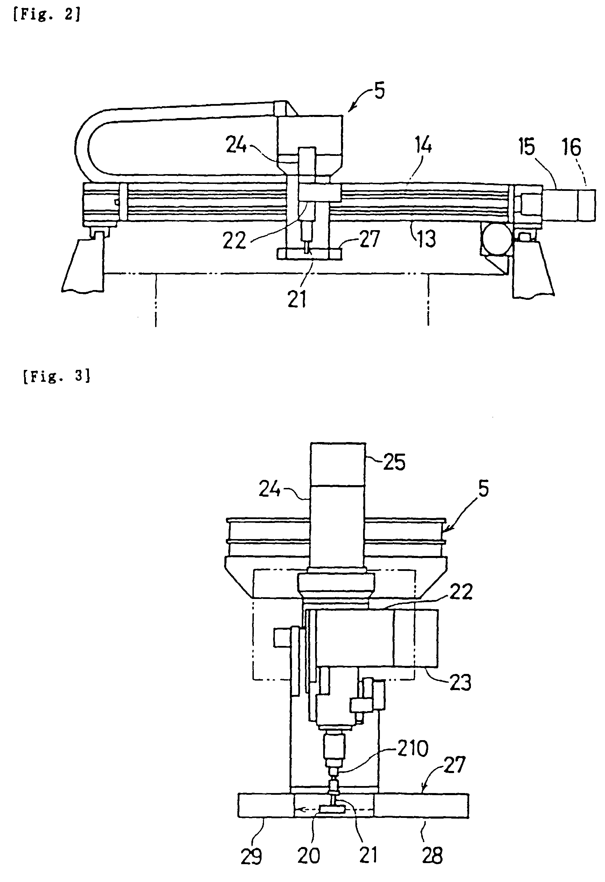

FIGs. 1 and 2 show an entire structure of a surface mounter according to an embodiment of this invention. Referring to these drawings, a conveyor (2) for conveying a printed circuit board (3) is arranged on a base (1) of a surface mounter so that the printed circuit board (3) is conveyed on the conveyor (2) and stopped at a specified mounting work position. On both sides of the conveyor (2) are arranged parts supply sections (4). The parts supply section (4) is provided with parts feeders such as multiple row tape feeders (4a).

A head unit (5) for mounting parts is provided above the base (1). The head unit (5) is made to be capable of moving between the parts supply section (4) and the parts mounting section where the printed circuit board (3) is placed. In this embodiment, the movement is possible in directions of X axis (the direction of the conveyor 2) and Y axis (the direction normal to the X axis in a horizontal plane).

In other words, on the base (1) are arranged stationary rails (7) in the direction of Y axis, and a ball screw shaft (8) driven for rotation by a Y axis servomotor (9). A head unit support member (11) is arranged on the stationary rails (7). A nut (12) provided on the stationary rail (7) engages with the ball screw shaft (8). An X direction guide member (13) and a ball screw shaft (14) driven by an X axis servomotor (15) are arranged on the support member (11). A head unit (5) is movably supported by the guide member (13). A nut (not shown) provided on the head unit (5) engages with the ball screw shaft (14). The support member (11) is moved by the Y axis servomotor (9) in the Y axis direction. The head unit (5) is moved by the X axis servomotor (15) in the X axis direction relative to the support member (11). The Y axis servomotor (9) and the X axis servomotor (15) are respectively provided with position detection means (10) and (16) respectively comprising an encoder and others.

As shown in FIG. 3, the head unit (5) is provided with a pickup nozzle (21) for picking up an electronic part (20) and for movements in directions of both Z axis (vertical) and rotation about an R axis (nozzle center axis), and with a Z axis servomotor (22) (vertical drive means) and an R axis servomotor (24) for the nozzle member (21). The Z axis servomotor (22) and the R axis servomotor (24) are respectively provided with position detection means (23) and (25) respectively comprising an encoder and others.

At the lower part of the head unit (5) is provided a laser unit (27) constituting optical detection means. As shown in FIG. 3, the laser unit (27) comprises a laser beam generating section (parallel light beam emitting section) (28) and a light receiving section (29) located to face each other on both sides of a space where the pickup nozzle (21) is located. When the laser beam emitted from the laser beam generating section (28) is received by the light receiving section (29) and the part (20) picked up by the pickup nozzle (21) is at a specified recognition height, part of the laser beam is intercepted by the part (20), and the projection of the part (20) is detected.

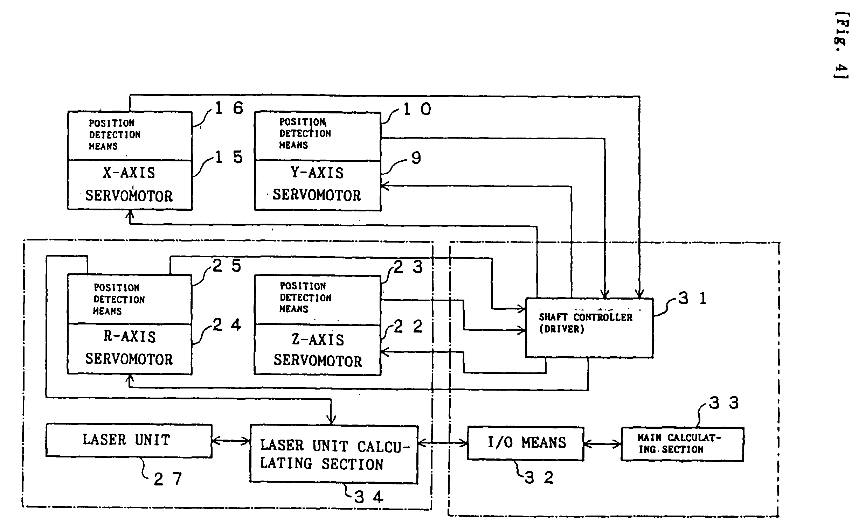

FIG. 4 shows an embodiment of a control system. In the figure, the mounter is provided with a main controller (30) comprising a shaft controller (driver) (31), input-output means (32), and a main operation section (33). The servomotors (9, 15, 22, and 24) respectively of the Y axis, X axis, Z axis, and R axis, and position detection means (10, 16, 23, and 25) provided respectively on those servomotors are connected to the shaft controller (31) which controls the drive of the servomotors (9, 15, 22, and 24). The laser unit (27) is electrically connected to a laser unit operation section (34) provided in the head unit (5). The laser unit operation section (34) is connected through the input-output means (32) to the main operation section (33).

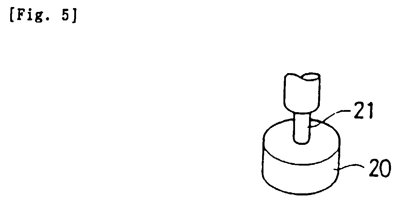

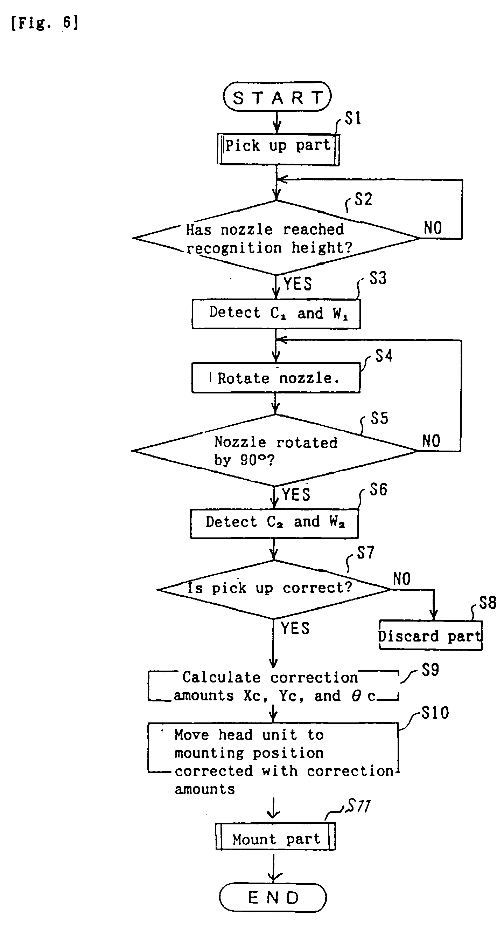

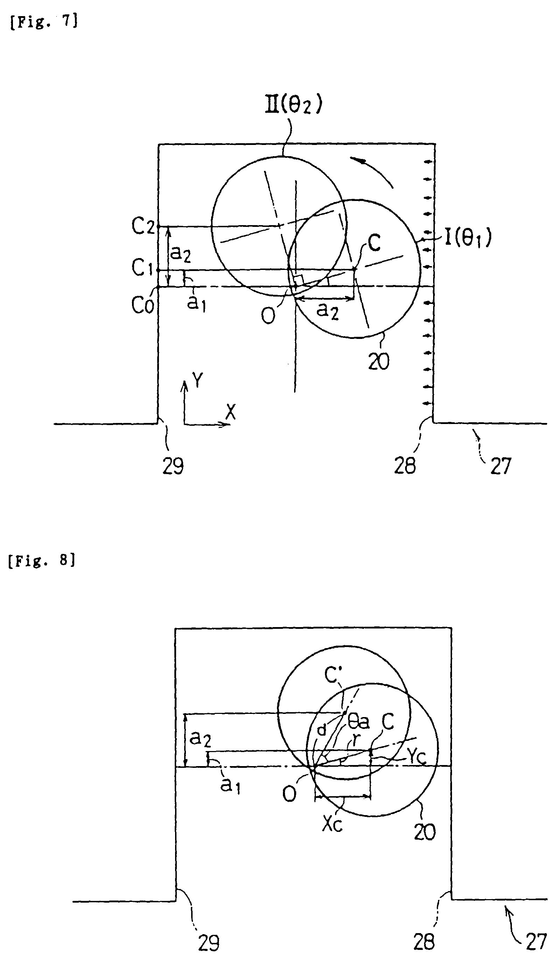

An embodiment of the part recognition method used in the mounting work using such a mounter will be described in reference to the operation diagram of FIG. 7 and using the flow chart of FIG. 6. The part (20) as an object of the method of this invention is of a low height cylindrical shape as shown in FIG. 5, and does not have polarity (rotary angle of the part is not restricted when it is mounted). One of such parts is a pad (a part like a base) for supporting an electric part. The cylindrical part (20) is picked up by the pickup nozzle (21).

The flow chart of FIG. 6 shows a process of a series of mounting steps from picking up the part and mounting it, and steps other than those for recognition characteristic of this invention are shown roughly. When the mounting process of this flow chart is started, the head unit (5) lowers to the parts supply section (4) and at the same time the pickup nozzle (21) lowers and picks up the cylindrical part (20) from the parts supply section (4) (step S1). After picking up the part, the pickup nozzle (21) rises to a specified recognition height corresponding to the laser unit (27) (step S2) and recognition is performed using the laser unit (27).

In this recognition process, first the pickup nozzle (21) is set to a first rotary angle θ₁ and under this state projection (shadow) of the cylindrical part (20) is detected by-the laser unit (27), and a part projection center position C₁ and a part projection width W₁ are detected (step S3). Here the first rotary angle θ₁ may be arbitrary, for example the same with the angle at which the part is picked up (without rotating the pickup nozzle 21 after picking up the part). Next, the pickup nozzle (21) is set to a second rotary angle θ₂ by rotating 90 degrees from the first rotary angle θ₁ (steps S4 and S5). Under this state, a part projection center position C₂ and a part projection width W₂ are detected in a similar process to that of the step S3 (step S6).

When the detections of projections at the first and second rotary angles θ₁ and θ₂ are over, the part is determined if it is picked up correctly (step S7). Here, if the part is picked up correctly, the part projection width W₁ is equal to the part projection width W₂ and corresponds to the diameter of the cylindrical part. Based on comparison of the part projection widths W₁ and W₂ with diameter data of the part, it is determined if the part is picked up correctly and, if not, the part is discarded (step S8).

If the part is picked up correctly, a mounting position correction amounts of Xc in the X direction and Yc in the Y direction are obtained from the part projection center positions C₁ and C₂ at the first and second rotary angles θ₁ and θ₂, and at the same time a rotary angle θc of the pickup nozzle (21) when the part is picked up is determined (step S9).

How to obtain the correction amount will be described below in reference to FIG. 7. If it is assumed that the part (20) is in the position I in the figure when the pickup nozzle (21) is at the first rotary angle θ₁, the part (20) is in the position II at the second rotary angle θ₂ as rotated by 90 degrees from the first position I about the nozzle center O. If a point on the light receiving section (29) corresponding to the center O of the pickup nozzle (21) is assumed as C₀ (C₀ will be hereinafter referred to as "the quasi nozzle center"), the distance between the part projection center position C₁ and the quasi nozzle center C₀ when the part (20) is in the position I is assumed as a₁, and the distance between the part projection center position C₂ and the quasi nozzle center C₀ when the part (20) is in the position II is assumed as a₂, the distances a₁ and a₂ correspond to amounts of deviation of the part center C from the nozzle center O in the Y and X directions respectively when the pickup nozzle (21) is at the first rotary angle θ₁.

Therefore in the step S9, it is determined that the correction amount Xc in the X direction is a₂, and that Yc in the Y direction is a₂.

Next the head unit (5) is moved to a position added with the correction amount (step S10), the rotary angle of the pickup nozzle (21) is adjusted, the pickup nozzle (21) lowered to the printed circuit board, and the part is mounted on the printed circuit board.

According to this method, even if the part (20) is picked up with a deviation, the correction amounts for the mounting position are determined according to the detection of the part projection using the laser unit (27). The part (20) is mounted by the pickup nozzle (21) accurately in the correct position corrected with the correction amounts on the printed circuit board. When the cylindrical part (20) is handled in particular, the part projection center position C₁ with the pickup nozzle (21) at the first rotary angle θ₁ and the part projection center position C₂ with the pickup nozzle (21) at the first rotary angle θ₂ are measured, deviation in the part pickup position is checked from the measured data, and the correction amounts for the mounting position are determined easily and accurately.

In the example above, while the rotary angle of the pickup nozzle (21) at the time of mounting the part is assumed as θ₁, the distance a₁ shown in FIG. 7 as the Y direction correction amount, and the distance a₂ as the X direction correction amount, it may also be assumed that the rotary angle of the pickup nozzle (21) at the time of mounting the part as θ₂, the distance a₁ as the X direction correction amount, and the distance a₂ as the Y direction correction amount.

In the above example, the angle between the first rotary angle θ₁ and the second rotary angle θ₂ is set to 90 degrees. However, even if the angle is set to a value other than 90 degrees, the mounting position correction amount can be obtained. This will be described in reference to FIG. 8. With the pickup nozzle (21) at the first rotary angle θ₁, it is assumed that the tilt angle of a line stretched between the nozzle center O and the part center C with respect to the X direction as θa, the distance between the nozzle center O and the part center C or C' (part deviation amount) as d, and the distances between the part projection center position and the quasi nozzle center position as a₁ and a₂ at the first and second rotary angles θ₁ and θ₂ respectively. Then, the following equations hold:$\text{(Equation 1)} {\text{a}}_{\text{1}} \text{= d·sin γ 1⃝} {\text{a}}_{\text{2}} \text{= d·sin(γ + θa)} \text{= d·sin γ·cos θa + d·cos γ·sin θa 2⃝}$ The correction amounts Xc and Yc in the X and Y directions are Xc = d·cos γ and Yc = d·sin γ. From the equations ① and ② above, these correction amounts are determined as follows:$\text{(Equation 2)} {\text{Xc = (a}}_{\text{2}} {\text{- a}}_{\text{1}} \text{·cos θa)/sin θa} {\text{Yc = a}}_{\text{1}}$

Therefore, the mounting position correction amounts can be determined from the preset angle θa and the distances a₁ and a₂ if the preset angle θa is any multiple of 0 and 180 degrees. However, if the angle is set to 90 degrees as shown in FIGs. 6 and 7, the mounting position correction amounts can be determined most easily.

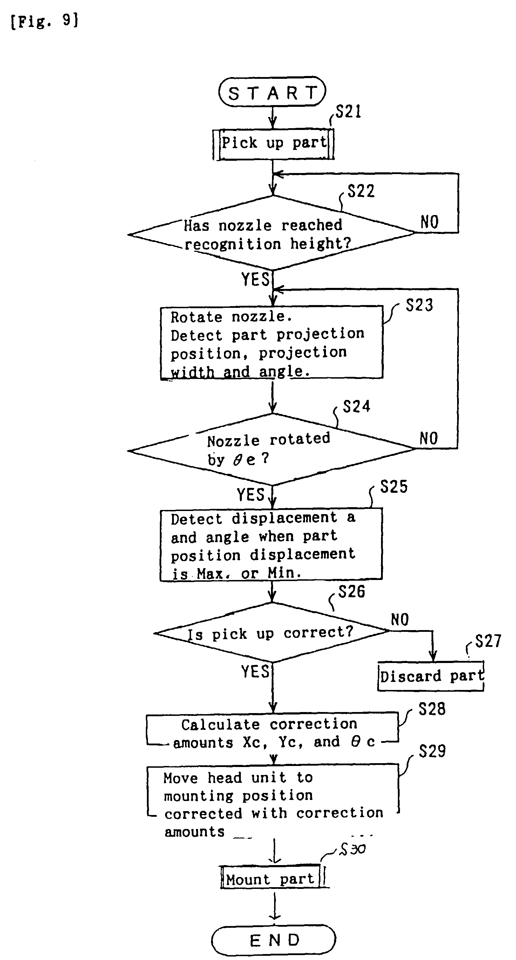

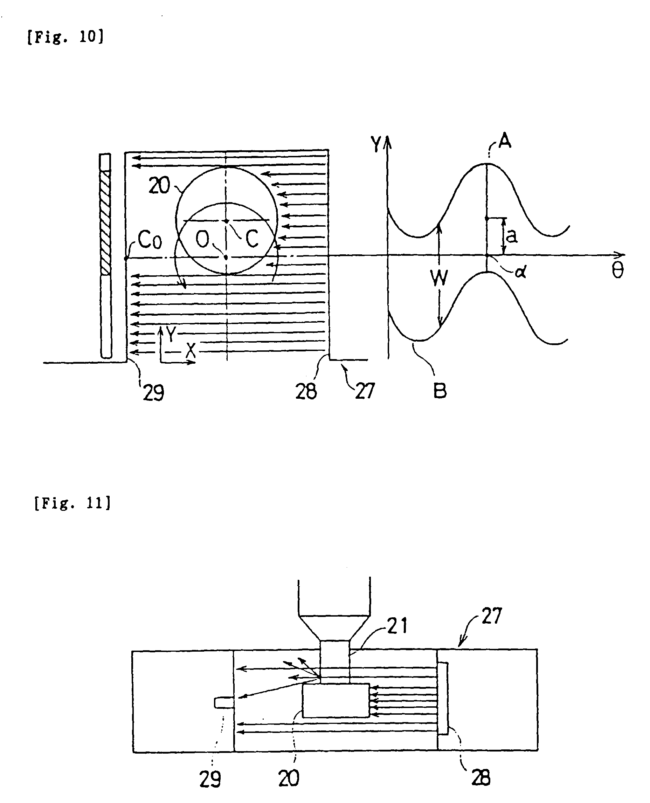

Another embodiment of the part recognition method will be described according to the flow chart of FIG. 9 in reference to FIG. 10 for explaining the function.

When the mounting process of this flow chart is started, the part is picked up (step S21), after the part is picked up, the pick up nozzle (21) is raised to a specified recognition height (step S22), and the recognition process is carried out using the laser unit (27).

This recognition process is as follows: While the pickup nozzle (21) is being rotated, the part projection position, projection width, and rotary angle are detected at every small rotary angle. This detection is repeated until the pickup nozzle is rotated up to a specified angle θe (for example 180 degrees). This provides, as will be described in detail later, data of relationship between the nozzle rotary angles and the part projection positions.

When the pickup nozzle is rotated up to a specified angle θe, displacement amount (a) of the part projection position and rotary angle (a) when the displacement amount (a) becomes the maximum or the minimum are determined according to the data collected up to that time (step S25).

Next, the part is checked if it is picked up correctly by comparing the projection width with the part diameter known from the parts data (step S26). If not correct, the part is discarded (step S27).

If the part is picked up correctly, the correction amounts Xc and Yc in the X and Y directions are determined from the displacement amount (a) and the rotary angle (α) determined in the step S25. At the same time, the rotary angle θc of the pickup nozzle at the time of picking up the part is determined (step S28).

How to determine the correction amounts in the steps S23 through S25 and ensuing step S28 will be specifically described in reference to FIG. 10. When the pickup nozzle (21) is rotated at the time of the part recognition after the part is picked up, the cylindrical part (20) picked up by the pickup nozzle (21) rotates about the nozzle center O as shown with an arrow in FIG. 10. If the part center C is displaced from the nozzle center O, the part projection width W does not change but the part projection position (part position in the Y direction) changes according to the rotation of the pickup nozzle (21). The change in the position with respect to the nozzle rotation angle depicts a sine curve as shown in the same figure. When the part projection position becomes the maximum (at the position A in the figure) or becomes the minimum (at the position B in the figure), the part center C is displaced in the Y direction with respect to the nozzle center 0. The displacement amount (a) of the part projection center position with respect to the quasi nozzle center C₀ at this time corresponds to the deviation amount of the pickup position.

Therefore in the above step S28, the nozzle rotation angle (α) when the part projection position becomes the maximum (or minimum) is determined as the nozzle rotation angle θc at the time of mounting the part, and the correction amounts Xc and Yc in the X and Y directions are determined as 0 and (a), respectively.

Next, the head unit (5) is moved to a position added with the correction amount (step S29), the rotation angle of the pickup nozzle (21) is adjusted, the pickup nozzle (21) is lowered to the printed circuit board, and the part is mounted.

Also by this method as an embodiment, the correction amount for the part mounting position can be determined simply and accurately according to the detection of the part projection using the laser unit (27). In particular, the deviation of the part pickup position is checked by the displacement amount (a) when the displacement amount of the part projection position becomes the maximum (or minimum) and the correction amount for the mounting position is determined simply and accurately.

According to the steps S23 and S24 of the flow chart of FIG. 9 of this embodiment, the pickup nozzle (21) is rotated by a specified angle θe (180 degrees). However, the pickup nozzle may be rotated by an angle at which the maximum or minimum displacement amount of the part projection position is found.

The specific structure of the mounter to which the method of this invention is applied is not limited to the one shown in the drawings but any structure may be used as long as the head unit (5) is provided with a pickup nozzle (21) capable of vertical and rotary movements, and with driving means for driving the nozzle, as well as a laser unit (27). Also, the specific structure of the pickup nozzle (21) can be made in various ways. Specific examples which are advantageous for improving accuracy in parts recognition and mounting will be described below.

The pickup nozzle (21) is usually made of metal such as stainless steel. However, a pickup nozzle having high metallic gloss or brightness may produce random reflection of the light beam irradiated from the laser generating section (28) on the nozzle surface at the time of the part recognition using the laser unit (27), and the reflected light beam might cause adverse effect on the part detection. Therefore, it is preferable for improving accuracy of the projection detection by the laser unit (27) by preventing random reflection on the nozzle surface, to finish the nozzle (21) surface with matted paint or form the nozzle (21) with black resin.

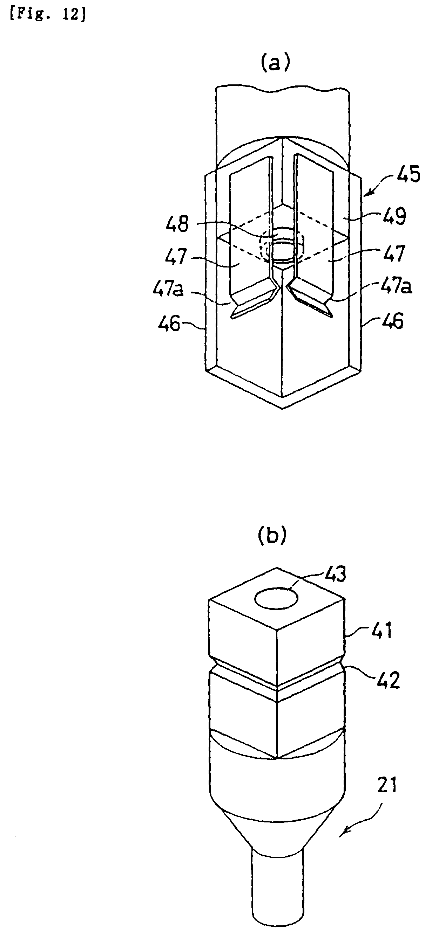

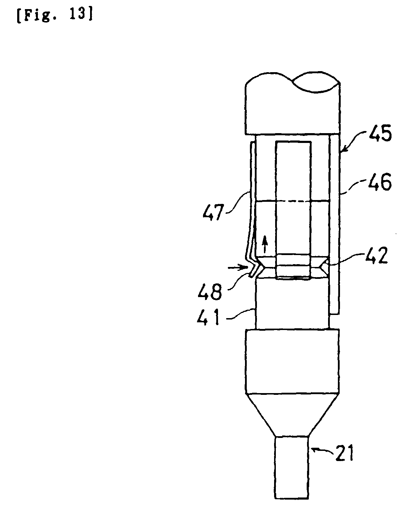

The pickup nozzle (21) is detachably attached to the nozzle shaft so that the nozzle system may be replaced with different ones according to the kinds of parts to be picked up. In particular, if the pickup nozzle (21) and the nozzle holder (45) for attaching the nozzle (21) are formed as shown in FIGs. 12(a), 12(b), and 13, the pickup nozzle (21) is attached firmly without play, while permitting the pickup nozzle (21) to be detachable.

In other words, in these drawings, in the upper part of the pickup nozzle (21) is provided an oblong square column portion (41) provided at its middle height on one side with a groove (42) of a triangular cross section. A nozzle hole (43) is made through from the top of the square column (41) to the bottom end of the nozzle. On the other hand, the nozzle holder (45) to be attached and fixed to the lower end of the nozzle shaft is provided with a bidirectional plate (46) facing two adjoining sides of four sides of the square column portion (41), and with two plate springs (47) facing other two sides of the square column portion (41). The lower end portion of each plate spring (47) is formed with an engagement portion (47a) of a triangular cross section projecting inward. The upper ends of the plate (46) and the plate springs (47) are secured to an upper block (49) of the nozzle holder (45). The upper block (49) is formed with a center through hole, and a cylindrical extension (48) to be fit into the nozzle hole (43) in the pickup nozzle (21).

According to this structure, the square column portion (41) of the pickup nozzle (21) is fit from under into the nozzle holder (45), and as shown in FIG. 13, the two sides of the square column portion (41) come into contact with the inner surfaces of the plates (46) of the nozzle holder (45). At the same time, the engagement portions (47a) of the plate springs (47) engage with the grooves (42) on the other two sides of the square column portion (41). Thus, the pickup nozzle (21) is held on the nozzle holder (45).

Under that state, as the square column portion (41) of the pickup nozzle (21) is pressed against the plates (46) by the plate springs (47), play in the X and Y directions is prevented and at the same time play in the rotary direction is also prevented as the square column portion (41) comes into surface contact with the bidirectional plate (46). Furthermore, play in the vertical directions is also prevented as the engagement portion (47a) of the plate spring (47) comes in press contact with the slope portion of the groove (42) so as to push up the square column portion (41) and presses it against the upper block (49).

Therefore, the pickup, recognition, and mounting of the part are made without causing play in the pickup nozzle (21), and stability and accuracy in those actions are assured. Furthermore, since the projection (48) is inserted into the nozzle hole (43) in the pickup nozzle (21), vacuum pressure applied to the pickup nozzle (21) is prevented from leaking.

As described above, the part recognizing method makes it possible to obtain the mounting position correction amount according to detection of the part projection using the optical detection means comprising a parallel light beam irradiating section and the light receiving section after the part is picked up. In particular, the mounting position correction amount is effectively obtained when the cylindrical part is the subject.

As described above, the part projection center positions are measured with the pickup nozzle which has picked up the part at the first rotary angle and at the second rotary angle as rotated by a preset angle from the first rotary angle, and the part mounting position correction amount is determined from the distance between the part projection center position and the quasi nozzle center position at each of the rotary angles. As a result, when the cylindrical part is the subject, the mounting position correction amount commensurate with the deviation in the pickup position is determined easily and accurately. In particular, when the second rotary angle is set to the one as rotated by 90 degrees from the first rotary angle, the mounting position correction amounts in the two perpendicularly intersecting directions can be determined easily and accurately.

Alternatively, the part projection position is measured while the pickup nozzle which has picked up the part is being rotated, the displacement amount is determined when the displacement amount of the part projection position becomes the maximum or minimum, and from the results the mounting position correction amount is determined. As a result, the mounting position correction amount is determined commensurate with the deviation in the picked up position easily and accurately when the cylindrical part is the subject.

## Claims

1. Method of mounting a part (20) at a specific position, in particular mounting an electronic part or an auxiliary part as for supporting the electronic part onto a substrate such as a printed circuit board (3), comprising the steps of picking up the part (20) by an attracting nozzle (21), transferring the part (20) and placing same within a detection area of an optical detection means (28,29), said optical detection means emits parallel light beams for detecting projected width data of the part (20), subjecting the part (20) to a recognition process, wherein said projected width data are obtained under rotation of the part (20), and mounting the part (20) at the desired position, said part is formed as a cylindrical part (20) having its central axis parallel or identical to an axis of said nozzle (21) and perpendicular to a plane which is defined by the detection area, comprising the steps of determining a first projected position of said part (20) attracted by said nozzle (21) within said detection area, by detecting a first central position (C₁) of the first projection of said part (20) within said detection area, rotating said part (20) by a predetermined rotary angle (θ₂,θₐ) from said first position to a second position within said detection area and determining said second projected position by detecting a second central position (C₂) of the second projection of said part (20) within said detection area and calculating a correction amount (Xc), which extends in line with the parallel light beams by the equation:${\text{Xc = (a}}_{\text{2}} {\text{- a}}_{\text{1}} \text{cos θa)/sin θa, and}$ a correction amount Yc, which extends perpendicular to Xc and within said detection area by the equation:${\text{Yc = a}}_{\text{1}} \text{,}$ wherein a₁ and a2 are defined by the distances between the detected central positions (C₁,C₂) of the projections of the part (20) and the projected position corresponding to the nozzle center (0) in a direction, which is in line with Yc, and wherein the angle θa corresponds to said predetermined rotary angle (θ₂,θₐ).

2. Method according to claim 1, **characterized in that** said part (20) is placed with a first rotary angle (θ₁;γ) in its first projected position, said first rotary angle (θ₁;γ) being set arbitrary.

3. Method according to claim 1 or 2, **characterized in that** said central positions (C₁,C₂) of the projections of the part (20) are detected by measuring regions of part projections and determining said central positions (C₁,C₂) of said regions.

4. Method according to at least one of the preceding claims 1 to 3, **characterized in that** at said first and second projected positions of said part (20), respectively, first and second part projection widths (W₁,W₂) are also detected.

5. Method according to claim 4, **characterized in that** after detection of projected widths (W₁,W₂) is finished, it is determined whether the part (20) is picked up correctly, whereas the first part projection width (W₁), the second part projection width (W2) and the diameter of said cylindrical part (20) are equal if the part (20) is picked up correctly, and whereas the part (20) is discarded if the part (20) is not picked up correctly.

6. Method according to at least one of the preceding claims 1 to 5, **characterized in that** after it is determined that the part (20) is picked up correctly, mounting position correction amounts (Xc,Yc,θc) are determined from distances between said detected central positions (C₁,C₂) and a position (C0) corresponding to the nozzle center (O) at both of said rotary angles (θ₁,θ₂;γ,θₐ) and wherein a correction amount for the rotary angle of the pick up nozzle (21) around a vertical nozzle axis is determined when the part (20) is picked up.

7. Method according to at least one of the preceding claims 1 to 6, **characterized in that** said predetermined rotary angle (θ₂;θₐ) is set to an arbitrary angle.

8. Method according to at least one of claims 1 to 7, **characterized in that** said predetermined rotary angle (θ₂) is set to 90°.

9. Method according to claim 8, **characterized in that** said two distances (a₁,a₂) between the part projection center positions (C₁,C₂) and said position of the nozzle center (0) at both rotary angles (θ₁,θ₂;γ,θₐ) correspond to the mounting position correction amounts (X_{c},Y_{c}), respectively, in two directions perpendicular to each other.

10. Method according to claim 8 or 9, **characterized in that** said first or said predetermined rotary angle corresponds to a corrected rotary angle for the mounting position.

11. Method according to at least one of claims 1 to 5, **characterized in that** said part (20) being subject to the light beams is rotated via said nozzle (21) around an axis (R-axis) substantially perpendicular to the light beams, and during rotation said projected position, said projection width and said rotary angle (8) are repeatedly detected.

12. Method according to claim 11, **characterized in that** said detection is repeated at every small rotary angle until the part (20) is rotated up to a specified angle (θe), which is preferably equal to 180°.

13. Method according to one of claims 11 or 12, **characterized by** determining a maximum or minimum displacement distance (a) between said projected position of said part (20) and a projected position corresponding to the nozzle center (0), said displacement distance (a) reaches said maximum or said minimum when a connecting line from a part center (C) to the nozzle center (0) extends substantially perpendicular to the parallel light beams and within said detection area.

14. Method according to claim 13, **characterized in that** said projected positions of said part (20) are determined by detecting central positions of the projections of the parts (20), and in that said maximum or minimum displacement distance corresponds to the correction amount (a) for a mounting position and a rotary angle, to which said part (20) is moved from said first projected position of said part (20) to said projected position having maximum or minimum displacement distance, corresponds to a corrected rotary angle (θc) for the mounting position.

15. Apparatus for mounting a part (20) at a specific position, particularly mounting an electronic part or an auxiliary part as for supporting the electronic part onto a substrate such as a printed circuit board (3), comprising a movable mounting head unit (5) having at least one attracting nozzle (21) for picking up at least one part (20) from a part supply unit (4), an optical detecting means (28,29) emitting parallel light beams in a detection area for detecting a projected width data of the part (20), a control unit for controlling the movement of the nozzle (21) in response to said projected width data, said part (20) is formed as a cylindrical part having its central axis parallel to or identical to an axis of said nozzle (21) and perpendicular to a plane which is defined by said detection area, in particular for performing the method of claim 1, wherein a calculating section is provided for determining a first projected position of said part (20) attracted by said nozzle (21) within said detection area by detecting a first central position (C₁) of the first projection of said part (20) within said detection area, said control unit rotating said part (20) by a predetermined rotary angle (θ₂,θₐ) from said first position to a second position within said detection area, said calculating section determines said second projected position by detecting a second central position (C₂) of the second projection of said part (20) within said detection area, and wherein the calculating section is adopted to calculate a correction amount (Xc), which extends in line with the parallel light beams by the equation:${\text{Xc = (a}}_{\text{2}} {\text{- a}}_{\text{1}} \text{cos θa)/sin θa, and}$ a correction amount Yc, which extends perpendicular to Xc and within said detection area by the equation:${\text{Yc = a}}_{\text{1}} \text{,}$ wherein a₁ and a₂ are defined by the distances between the detected central positions (C₁,C₂) of the projections of the part (20) and the projected position corresponding to the nozzle center (0) in a direction, which is in line with Yc, and wherein the angle θa corresponds to said predetermined rotary angle (θ₂,θₐ).

16. Apparatus according to claim 15, **characterized in that** at least a surface of the nozzle (21) is painted with a matted and/or a dark colour or in that said nozzle (21) is formed with black resin.

17. Apparatus according to claim 15 or 16, **characterized in that** an upper part of the nozzle (21) is provided with a connecting means, which allows the nozzle (21) to be detachabley inserted into a receiving means of a nozzle holder (45), so that said nozzle (21) is attached into said receiving means substantially without play.

18. Apparatus according to claim 17, **characterized in that** said receiving means comprises two plates (46), which are disposed relatively to each other bi-directional, and which allow to bring the upper part of the nozzle (21) into abutting contact with the plates (46), and in that spring means are provided for pressing the upper part of the nozzle (21) against the bi-directional plates (46).

19. Apparatus according to claim 18, **characterized in that** said upper part of said nozzle (21) is provided with an oblong square column portion (41), which has formed at substantially its middle height a groove (42) of a triangular cross-section, and in that said nozzle is provided with a nozzle hole (43) which extends from the top of the square column (41) to the bottom end of the nozzle (21).

20. Apparatus according to claim 18, **characterized in that** said bi-directional plates (46) of said nozzle holder (45) are disposed relatively to the upper part of the nozzle (21) such that two adjoining sides of four sides of the square column portion (41) are facing two bi-directional plates (46) and in that said spring means are formed as two-plate springs (47) facing the other two adjoining sides of the square column portion (41).

21. Apparatus according to claim 20, **characterized in that** each of said plate springs (47) is formed at its lower end portion with an engagement portion (47a) of a triangular cross-section, which projects inward and which fits into the grooves (42) of the nozzle (21) in an inserted status of the nozzle (21).

## Patentansprüche

1. Verfahren zur Montage eines Teils (20) in einer spezifischen Position, insbesondere zur Montage eines elektronischen Teils oder eines Hilfsteils zum Halten des elektronischen Teils auf einem Substrat, wie etwa einer Druckschaltkarte (3), enthaltend die folgenden Schritte: Aufnahme des Teils (20) mit einer Anziehungsdüse (21), Übertragen des Teils (20) und Plazieren desselben innerhalb eines Erfassungsbereiches einer optischen Detektoreinrichtung (28, 29), wobei diese optische Detektoreinrichtung parallele Lichtstrahlen aussendet, um projizierte Breitendaten des Teils (20) zu erfassen, Aussetzen des Teils (20) einem Erkennungsvorgang, wobei man die projizierten Breitendaten unter Rotation des Teils (20) erhält, und Montieren des Teils (20) in der gewünschten Position, wobei das Teil als zylindrisches Teil (20) ausgebildet ist, dessen Mittenachse parallel zu oder identisch mit einer Achse der Düse (21) und senkrecht zu einer Ebene verläuft, die durch den Erfassungsbereich definiert ist, enthaltend folgende Schritte: Bestimmen einer ersten projizierten Position des Teils (20), das mit der Düse (21) angezogen wird, innerhalb des Erfassungsbereiches durch Erfassen einer ersten zentralen Position (C₁) der ersten Projektion des Teils (20) innerhalb des Erfassungsbereiches, Drehen des Teils (20) um einen vorbestimmten Drehwinkel (θ₂, θₐ) aus der ersten Position in eine zweite Position innerhalb des Erfassungsbereiches und Bestimmen der zweiten projizierten Position durch Erfassen einer zweiten zentralen Position (C₂) der zweiten Projektion des Teils (20) innerhalb des Erfassungsbereiches und Berechnen einer Korrekturgröße (Xc), die sich in einer Linie mit den parallelen Lichtstrahlen erstreckt, mit der Gleichung:${\text{Xc = (a}}_{\text{2}} {\text{- a}}_{\text{1}} {\text{cos θ}}_{\text{a}} {\text{)/sin θ}}_{\text{a}} \text{, und}$ einer Korrekturgröße Yc, die sich senkrecht zu Xc und innerhalb des Erfassungsbereiches erstreckt, mit der Gleichung:${\text{Yc = a}}_{\text{1}} \text{,}$ wobei a₁ und a₂ durch die Abstände zwischen den erfaßten zentralen Positionen (C₁, C₂) der Projektionen des Teils (20) und der der Düsenmitte (0) entsprechenden projizierten Position in einer Richtung, die in einer Linie mit Yc verläuft, definiert sind und der Winkel θₐ dem vorbestimmten Drehwinkel (θ₂, θₐ) entspricht.

2. Verfahren nach Anspruch 1, dadurch gekennzeichnet, daß das Teil (20) mit einem ersten Drehwinkel (θ₁; γ) in seiner ersten projizierten Position plaziert wird, wobei dieser erste Drehwinkel (θ₁; γ) willkürlich eingestellt ist.

3. Verfahren nach Anspruch 1 oder 2, dadurch gekennzeichnet, daß die zentralen Positionen (C₁, C₂) der Projektionen des Teils (20) durch Messen der Bereiche der Teilprojektionen und Bestimmen der zentralen Positionen (C₁, C₂) dieser Bereiche erfaßt werden.

4. Verfahren nach wenigstens einem der vorhergehenden Ansprüche 1 bis 3, dadurch gekennzeichnet, daß in den ersten bzw. zweiten projizierten Positionen des Teils (20) die ersten und zweiten Teilprojektionsbreiten (W₁, W₂) ebenfalls erfaßt werden.

5. Verfahren nach Anspruch 4, dadurch gekennzeichnet, daß nachdem die Erfassung der projizierten Breiten (W₁, W₂) beendet ist, bestimmt wird, ob das Teil (20) korrekt aufgenommen ist, wobei die erste Teilprojektionsbreite (W₁), die zweite Teilprojektionsbreite (W₂) und der Durchmesser des zylindrischen Teils (20) gleich sind, wenn das Teil (20) korrekt aufgenommen ist und das Teil (20) ausgeschieden wird, wenn das Teil (20) nicht korrekt aufgenommen ist.

6. Verfahren nach wenigstens einem der vorhergehenden Ansprüche 1 bis 5, dadurch gekennzeichnet, daß nach Bestimmung der korrekten Aufnahme des Teils (20) Montagepositions-Korrekturgrößen (Xc, Yc, θ_{c}) aus den Abständen zwischen den erfaßten zentralen Positionen (C₁, C₂) und einer Position (C0), die mit der Düsenmitte (0) in beiden Drehwinkeln (θ₁, θ₂; γ, θₐ) korrespondiert, erfaßt werden und eine Korrekturgröße für den Drehwinkel der Aufnahmedüse (21) um eine vertikale Düsenachse ermittelt wird, wenn das Teil (20) aufgenommen ist.

7. Verfahren nach wenigstens einem der vorhergehenden Ansprüche 1 bis 6, dadurch gekennzeichnet, daß der vorbestimmte Drehwinkel (θ₂, θₐ) auf einen willkürlichen Winkel eingestellt ist.

8. Verfahren nach wenigstens einem der Ansprüche 1 bis 7, dadurch gekennzeichnet, daß der vorbestimmte Winkel (θ₂) auf 90° eingestellt ist.

9. Verfahren nach Anspruch 8, dadurch gekennzeichnet, daß die beiden Entfernungen (a₁, a₂) zwischen den Teilprojektions-Zentralpositionen (C₁, C₂) und der Düsenmitte (0) in beiden Drehwinkeln (θ₁, θ₂; γ, θₐ) jeweils den Montagepositions-Korrekturgrößen (X_{c}, Y_{c}) in zwei Richtungen senkrecht zueinander entsprechen.

10. Verfahren nach Anspruch 8 oder 9, dadurch gekennzeichnet, daß der erste oder vorbestimmte Drehwinkel einem korrigierten Drehwinkel für die Montageposition entspricht.

11. Verfahren nach wenigstens einem der Ansprüche 1 bis 5, dadurch gekennzeichnet, daß das Teil (20), das den Lichtstrahlen ausgesetzt ist, mit Hilfe der Düse (21) um eine Achse (R-Achse) gedreht wird, die im wesentlichen senkrecht zu den Lichtstrahlen verläuft, und während der Drehung die projizierte Position, die Projektionsbreite und der Drehwinkel (θ) wiederholt erfaßt werden.

12. Verfahren nach Anspruch 11, dadurch gekennzeichnet, daß die Erfassung bei jedem kleinen Drehwinkel wiederholt wird, bis das Teil (20) bis zu einem spezifizierten Winkel (θe) gedreht ist, der vorzugsweise 180° beträgt.

13. Verfahren nach einem der Ansprüche 11 oder 12, kennzeichnet durch Ermitteln eines maximalen oder minimalen Verschiebungsabstandes (a) zwischen der projizierten Position des Teils (20) und einer projizierten Position , die der Düsenmitte (0) entspricht, wobei dieser Verschiebungsabstand (a) das Maximum oder Minimum erreicht, wenn sich eine Verbindungslinie von einer Teilmitte (C) zur Düsenmitte (0) im wesentlichen senkrecht zu den parallelen Lichtstrahlen und innerhalb des Erfassungsbereiches erstreckt.

14. Verfahren nach Anspruch 13, dadurch gekennzeichnet, daß die projizierten Positionen des Teils (20) ermittelt werden, indem die zentralen Positionen der Projektionen der Teile (20) bestimmt werden, und dadurch, daß der maximale oder minimale Verschiebungsabstand der Korrekturgröße (a) für eine Montageposition entspricht und ein Drehwinkel, in den das Teil (20) von der ersten projizierten Position des Teils (20) in die projizierte Position bewegt wird, die den maximalen oder minimalen Verschiebungsabstand aufweist, einem korrigierten Drehwinkel (θ_{c}) für die Montageposition entspricht.

15. Gerät zur Montage eines Teils (20) in eine spezifische Position, insbesondere zur Montage eines elektronischen Teils oder eines Hilfsteils zum Halten des elektronischen Teils auf einem Substrat, wie etwa einer gedruckten Schaltkarte (3), enthaltend einen bewegliche Montagekopfeinheit (5) mit wenigstens einer Anziehungsdüse (21) zur Aufnahme wenigstens eines Teils (20) von einem Teilevorrat (4), eine optische Detektoreinrichtung (28, 29), die parallele Lichtstrahlen in einen Erfassungsbereich zum Erfassen von Projektionsbreitendaten des Teils (20) abstrahlt, eine Steuereinheit zum Steuern der Bewegung der Düse (21) in Abhängigkeit der Projektionsbreitendaten, wobei das Teil (20) als zylindrisches Teil ausgebildet ist, dessen Mittelachse parallel zu oder identisch mit einer Achse der Düse (21) ist und senkrecht zu einer Ebene verläuft, die durch den Erfassungsbereich definiert ist, insbesondere zur Ausführung des Verfahrens aus Anspruch 1, wobei ein Berechnungsabschnitt vorgesehen ist, um eine erste projizierte Position des Teils (20), das mit der Düse (21) angezogen wird, innerhalb des Erfassungsbereiches dadurch zu ermitteln, daß eine erste zentrale Position (C₁) der ersten Projektion des Teils (20) innerhalb des Erfassungsbereiches erfaßt wird, die Steuereinheit das Teil (20) um einen vorbestimmten Drehwinkel (θ₂, θₐ) aus der ersten Position in eine zweite Position innerhalb des Erfassungsbereiches dreht, der Berechnungsabschnitt die zweite projizierte Position durch Erfassen einer zweiten zentralen Position (C₂) der zweiten Projektion des Teils (20) innerhalb des Erfassungsbereiches bestimmt, und der Berechnungsabschnitt dazu eingerichtet ist, eine Korrekturgröße (Xc), die sich in einer Linie mit den parallelen Lichtstrahlen erstreckt mit der Gleichung:${\text{Xc = (a}}_{\text{2}} {\text{- a}}_{\text{1}} {\text{cos θ}}_{\text{a}} {\text{)/sin θ}}_{\text{a}} \text{, und}$ eine Korrekturgröße Yc, die sich senkrecht zu Xc und innerhalb des Erfassungsbereiches erstreckt, mit der Gleichung:${\text{Yc = a}}_{\text{1}}$ zu errechnen, wobei a₁ und a₂ durch die Abstände zwischen den erfaßten zentralen Positionen (C₁, C₂) der Projektionen des Teils (20) und der der Düsenmitte (O) entsprechenden projizierten Position in einer Richtung, die in einer Linie mit Yc verläuft, entspricht und der Winkel θₐ dem vorbestimmten Drehwinkel (θ₂, θₐ) entspricht.

16. Gerät nach Anspruch 15, dadurch gekennzeichnet, das wenigstens eine Oberfläche der Düse (21) mit einer matten und/oder dunklen Farbe gestrichen ist oder die Düse (21) aus schwarzem Kunststoff gefertigt ist.

17. Gerät nach Anspruch 15 oder 16, dadurch gekennzeichnet, daß ein oberer Teil der Düse (21) mit einer Verbindungseinrichtung ausgestattet ist, die es erlaubt, daß die Düse (21) herausnehmbar in eine Aufnahmeeinrichtung eines Düsenhalters (45) eingesetzt werden kann, so daß die Düse (21) in der Aufnahmeeinrichtung im wesentlichen ohne Spiel angebracht ist.

18. Gerät nach Anspruch 17, dadurch gekennzeichnet, daß die Aufnahmeeinrichtung zwei Platten (46) enthält, die relativ zueinander bidirektional angeordnet sind und die es zulassen, daß der obere Teil der Düse (21) gegen die Platten (46) stößt, und dadurch, daß Federeinrichtungen vorgesehen sind, um den oberen Teil der Düse (21) gegen die bidirektionalen Platten (46) zu drücken.

19. Gerät nach Anspruch 18, dadurch gekennzeichnet, daß der obere Teil der Düse (21) mit einem länglichen quadratischen Säulenabschnitt (41) ausgestattet ist, in dessen im wesentlichen mittlerer Höhe eine Rille (42) mit dreieckigem Querschnitt ausgebildet ist, und dadurch, daß die Düse mit einer Düsenbohrung (43) versehen ist, die sich von der Oberseite der rechteckigen Säule (41) zum unteren Ende der Düse (21) erstreckt.

20. Gerät nach Anspruch 18, dadurch gekennzeichnet, daß die bidirektionalen Platten (46) des Düsenhalters (45) relativ zum oberen Abschnitt der Düse (21) derart angeordnet sind, daß zwei zusammentreffende Seiten von vier Seiten des quadratischen Säulenabschnitts (41) zwei bidirektionalen Platten (46) gegenüberliegen, und dadurch, daß die Federeinrichtungen als zwei-blättrige Federn (47) ausgebildet sind, die den anderen beiden aufeinandertreffenden Seiten des rechteckigen Säulenabschnitts (41) gegenüberliegen.

21. Gerät nach Anspruch 20, dadurch gekennzeichnet, daß am unteren Endabschnitt jeder Blattfeder (47) ein Eingreifabschnitt (47a) mit dreieckigem Querschnitt ausgebildet ist, der sich nach innen erstreckt und in die Rillen (42) der Düse (21) in eingesetztem Zustand der Düse (21) paßt.

## Revendications

1. Procédé de montage d'un composant (20) en une position spécifique, s'agissant en particulier du montage d'un composant électronique ou d'un composant auxiliaire destiné à supporter le composant électronique sur un substrat tel qu'une carte de circuit imprimé (3), comprenant les étapes consistant à saisir le composant (20) à l'aide d'une buse attirante (21), à transférer le composant (20) et à placer celui-ci dans une zone de détection d'un moyen de détection optique (28, 29), ledit moyen de détection optique émet des faisceaux de lumière parallèles pour détecter des données de largeur projetée du composant (20), à soumettre le composant (20) à un processus de reconnaissance, dans lequel lesdites données de largeur projetée sont obtenues par rotation du composant (20), et à monter le composant (20) en la position souhaitée, ledit composant est formé en tant que composant cylindrique (20) ayant son axe central parallèle ou identique à un axe de ladite buse (21) et perpendiculaire à un plan qui est défini par la zone de détection, comprenant les étapes consistant à déterminer une première position projetée dudit composant (20) attiré par ladite buse (21) dans ladite zone de détection, en détectant une première position centrale (C₁) de la première projection dudit composant (20) dans ladite zone de détection, à faire tourner ledit composant (20) d'un angle de rotation prédéterminé (θ₂, θₐ) de ladite première position à une seconde position dans ladite zone de détection et à déterminer ladite seconde position projetée en détectant une seconde position centrale (C₂) de la seconde projection dudit composant (20) dans ladite zone de détection et à calculer une valeur de correction (Xc), qui s'étend en ligne avec les faisceaux de lumière parallèles en satisfaisant à l'équation :${\text{Xc = (a}}_{\text{2}} {\text{-a}}_{\text{1}} \text{cos θa)/sin θa, et}$ une valeur de correction Yc, qui s'étend perpendiculairement à Xc et dans ladite zone de détection, en satisfaisant à l'équation :${\text{Yc = a}}_{\text{1}} \text{,}$ dans lesquelles a₁ et a₂ sont définis par les distances entre les positions centrales détectées (C₁, C₂) des projections du composant (20) et la position projetée correspondant au centre de buse (0) selon une direction, qui est en ligne avec Yc, et dans lesquelles l'angle θa correspond audit angle de rotation prédéterminé (θ₂, θₐ).

2. Procédé selon la revendication 1, caractérisé en ce que ledit composant (20) est placé en faisant un premier angle de rotation (θ₁; γ) en sa première position projetée, ledit premier angle de rotation (θ₁ ; γ) étant fixé de façon arbitraire.

3. Procédé selon la revendication 1 ou 2, caractérisé en ce que lesdites positions centrales (C₁, C₂) des projections du composant (20) sont détectées en mesurant les zones des projections du composant et en déterminant lesdites positions centrales (C₁, C₂) desdites zones.

4. Procédé selon au moins l'une des revendications précédentes 1 à 3, caractérisé en ce que auxdites première et seconde positions projetées dudit composant (20), respectivement, des première et seconde largeurs de projection de composant (W₁, W₂) sont également détectées.

5. Procédé selon la revendication 4, caractérisé en ce qu'après que la détection des largeurs projetées (W₁, W₂) soit terminée, il est déterminé si le composant (20) est convenablement saisi ou non, tandis que la première largeur de projection de composant (W₁), la seconde largeur de projection de composant (W₂) et le diamètre dudit composant cylindrique (20) sont égaux si le composant (20) est saisi convenablement, et tandis que le composant (20) est rejeté si le composant (20) n'est pas convenablement saisi.

6. Procédé selon au moins l'une des revendications précédentes 1 à 5, caractérisé en ce qu'après qu'il soit déterminé que le composant (20) a été convenablement saisi, les valeurs de correction de position de montage (Xc, Yc, θc) sont déterminées à partir des distances entre lesdites positions centrales détectées (C₁, C₂) et une position (C0) correspondant au centre de buse (0) aux deux desdits angles de rotation (θ₁, θ₂ ; γ, θₐ), et dans lequel une valeur de correction de l'angle de rotation de la buse de saisissement (21) autour d'un axe de buse vertical est déterminée lorsque le composant (20) est saisi.

7. Procédé selon au moins l'une des revendications précédentes 1 à 6, caractérisé en ce que ledit angle de rotation prédéterminé (θ₂ ; θₐ) est fixé à un angle arbitraire.

8. Procédé selon au moins l'une des revendications 1 à 7, caractérisé en ce que ledit angle de rotation prédéterminé (θ₂) est fixé à 90°.

9. Procédé selon la revendication 8, caractérisé en ce que lesdites deux distances (a₁, a₂) entre les positions centrales de projection de composant (C₁, C₂) et ladite position du centre de buse (0) aux deux angles de rotation (θ₁, θ₂ ; γ, θₐ) correspondent aux valeurs de correction de position de montage (X_{c}, Y_{c}), respectivement, selon deux directions perpendiculaires l'une à l'autre.

10. Procédé selon la revendication 8 ou 9, caractérisé en ce que ledit premier ou ledit angle de rotation prédéterminé correspond à un angle de rotation corrigé de la position de montage.

11. Procédé selon au moins l'une des revendications 1 à 5, caractérisé en ce que ledit composant (20) étant soumis aux faisceaux de lumière est tourné via ladite buse (21) autour d'un axe (axe R) sensiblement perpendiculaire aux faisceaux de lumière, et au cours de la rotation de ladite position projetée, ladite largeur de projection et ledit angle de rotation (θ) sont détectés de façon répétitive.

12. Procédé selon la revendication 11, caractérisé en ce que ladite détection est répétée pour chaque petit angle de rotation jusqu'à ce que le composant (20) soit tourné d'un angle spécifié (θe) qui est, de préférence, égal à 180°.

13. Procédé selon l'une des revendications 11 ou 12, caractérisé par la détermination d'une distance de déplacement maximale ou minimale (a) entre ladite position projetée dudit composant (20) et une position projetée correspondant au centre de buse (0), ladite distance de déplacement (a) atteint ladite valeur maximale ou ladite valeur minimale lorsqu'une ligne de liaison issue d'un centre de composant (C) au centre de buse (0) s'étend sensiblement perpendiculairement aux faisceaux de lumière parallèles et dans ladite zone de détection.

14. Procédé selon la revendication 13, caractérisé en ce que lesdites positions projetées dudit composant (20) sont déterminées en détectant les positions centrales des projections du composant (20), et en ce que ladite distance de déplacement maximale ou minimale correspond à la valeur de correction (a) d'une position de montage et d'un angle de rotation, auxquels ledit composant (20) est déplacé à partir de ladite première position projetée dudit composant (20) à ladite position projetée ayant la distance de déplacement maximale ou minimale, en correspondant à un angle de rotation corrigé (θc) de la position de montage.

15. Appareil pour monter un composant (20) en une position spécifique, en particulier pour monter un composant électronique ou un composant auxiliaire pour que le composant électronique soit supporté sur un substrat tel qu'une carte de circuit imprimé (3), comprenant une unité de tête de montage mobile (5) ayant au moins une buse attirante (21) pour saisir au moins un composant (20) à partir d'une unité d'alimentation en composant (4), un moyen de détection optique (28, 29) émettant des faisceaux de lumière parallèles dans une zone de détection pour détecter des données de largeurs projetées du composant (20), une unité de commande pour commander le déplacement de la buse (21) en réponse auxdites données de largeurs projetées, ledit composant (20) est formé en tant que composant cylindrique ayant son axe central parallèle ou identique à un axe de ladite buse (21) et perpendiculaire à un plan qui est défini par ladite zone de détection, en particulier pour mettre en oeuvre le procédé selon la revendication 1, dans lequel un étage de calcul est prévu pour déterminer une première position projetée dudit composant (20) attiré par ladite buse (21) dans ladite zone de détection en détectant une première position centrale (C₁) de la première projection dudit composant (20) dans ladite zone de détection, ladite unité de commande faisant tourner ledit composant (20) d'un angle de rotation prédéterminé (θ₂, θₐ) de ladite première position à une seconde position dans ladite zone de détection, ledit étage de calcul détermine ladite seconde position projetée en détectant une seconde position centrale (C₂) de la seconde projection dudit composant (20) dans ladite zone de détection, et dans lequel l'étage de calcul est conçu pour calculer une valeur de correction (Xc), qui s'étend en ligne avec les faisceaux de lumière parallèles en satisfaisant à l'équation :${\text{Xc = (a}}_{\text{2}} {\text{-a}}_{\text{1}} \text{cos θa)/sin θa, et}$ une valeur de correction Yc, qui s'étend perpendiculairement à Xc et dans ladite zone de détection, en satisfaisant à l'équation :${\text{Yc = a}}_{\text{1}} \text{,}$ dans lesquelles a₁ et a₂ sont définis par les distances entre les positions centrales détectées (C₁, C₂) des projections du composant (20) et la position projetée correspondant au centre de buse (0) selon une direction, qui est en ligne avec Yc, et dans lesquelles l'angle θa correspond audit angle de rotation prédéterminé (θ₂, θₐ).

16. Appareil selon la revendication 15, caractérisé en ce qu'au moins une surface de la buse (21) est revêtue d'une couleur mate et/ou sombre ou en ce que ladite buse (21) est formée en une résine noire.

17. Appareil selon la revendication 15 ou 16, caractérisé en ce qu'une partie supérieure de la buse (21) comporte un moyen de connexion qui permet à la buse (21) d'être insérée de façon amovible dans un moyen récepteur d'un porte-buse (45), de sorte que ladite buse (21) est fixée dans ledit moyen récepteur sensiblement sans jeu.

18. Appareil selon la revendication 17, caractérisé en ce que ledit moyen récepteur comprend deux plaques (46) qui sont disposées de façon bidirectionnelle l'une par rapport à l'autre, et qui permettent d'amener la partie supérieure de la buse (21) en contact d'aboutement avec les plaques (46), et en ce que des moyens à ressorts sont prévus pour presser la partie supérieure de la buse (21) contre les plaques bidirectionnelles (46).

19. Appareil selon la revendication 18, caractérisé en ce que ladite partie supérieure de ladite buse (21) comporte une partie de colonne carrée et allongée (41), qui présente sensiblement à sa mi-hauteur une gorge (42) ayant une section droite triangulaire, et en ce que ladite buse comporte un orifice de buse (43) qui s'étend de la partie supérieure de la colonne carrée (41) à l'extrémité inférieure de la buse (21).

20. Appareil selon la revendication 18, caractérisé en ce que lesdites plaques bidirectionnelles (46) dudit porte-buse (45) sont disposées relativement à la partie supérieure de la buse (21) de telle sorte que deux côtés adjacents des quatre côtés de la partie de colonne carrée (41) sont tournés vers les deux plaques bidirectionnelles (46) et en ce que lesdits moyens à ressort sont formés en tant que ressorts à deux lames (47) tournés vers les deux autres côtés adjacents de la partie de colonne carrée (41).

21. Appareil selon la revendication 20, caractérisé en ce que chacun desdits ressorts à lames (47) est formé à sa partie d'extrémité inférieure d'une partie d'engagement (47a) présentant une section droite triangulaire, qui est en saillie vers l'intérieur et qui se monte dans les gorges (42) de la buse (21) dans un état inséré de la buse (21).
